# EUROPÄISCHE PATENTSCHRIFT

(11) **EP 0 750 345 B1**
(45) Veröffentlichungstag und Bekanntmachung des Hinweises auf die Patenterteilung: **01.09.2004**
(21) Anmeldenummer: 96109428.1
(22) Anmeldetag: 12.06.1996
(51) Int. Cl.: H01L 25/16, H01L 23/538, H01L 25/07

(54) **Leistungs-Halbleitermodul**
Power semiconductor module
Module semi-conducteur de puissance

(30) Priorität: 19.06.1995 DE 19522173
(43) Veröffentlichungstag der Anmeldung: 27.12.1996
(73) Patentinhaber: eupec Europäische Gesellschaft für Leistungshalbleiter mbH & Co. KG, 59581 Warstein (DE)
(72) Erfinder: Lenninger, Andreas, Dr.-Ing., 59609 Anröchte (DE)
(74) Vertreter: Patentanwälte Westphal, Mussgnug & Partner

(56) Entgegenhaltungen:
- DE-U- 9 313 483
- US-A- 5 325 268
- H. LEMME: "IGBT auf dem Siegeszug" ELEKTRONIK, Bd. 37, Nr. 15, 22.Juli 1988, MÜNCHEN, Seiten 33-34, XP002065278
- PATENT ABSTRACTS OF JAPAN vol. 006, no. 254 (E-148), 14.Dezember 1982 & JP 57 153460 A (NIPPON DENKI KK), 22.September 1982,

## Beschreibung

Die Erfindung bezieht sich auf ein Leistungs-Halbleitermodul mit einem Gehäuse und einem metallenen Boden, auf dem elektrisch isolierende und thermisch leitende, Leitbahnen tragende Substrate angeordnet sind, mit sechs nebeneinander liegenden steuerbaren Leistungs-Halbleiterschaltern, die jeweils auf einer der Leitbahnen elektrisch leitend befestigt sind, mit Laststromanschlüssen, die mit der Gehäusewand verbunden sind und die an der Unterseite im Inneren des Gehäuses Bondflächen haben, die über Bonddrähte elektrisch mit den steuerbaren Leistungs-Halbleiterschaltern verbunden sind.

Ein solches Leistungs-Halbleitermodul ist auf dem Markt und wird z.B. im Kurzkatalog 1993/94 "SIPMOS-Halbleiter", Seite 35 angeboten. Es enthält als Leistungs-Halbleiterschalter sechs IGBT, die zu einer Dreiphasen-Stromrichterbrücke zusammengeschaltet sind. Das Modul hat zwei Gleichstromanschlüsse und drei Wechselstromanschlüsse. Diese Anschlüsse führen den Laststrom.

Von Anwenderseite besteht oft der Wunsch, ein Leistungs-Halbleitermodul der beschriebenen Art z.B. in Form von drei Einzelschaltern für jeweils den doppelten Laststrom oder als Brückenzweig für den dreifachen Laststrom des Dreiphasen-Stromrichtermoduls zu betreiben. Dies erforderte bisher Änderungen des Layouts der Leiterbahnen.

Der Erfindung liegt die Aufgabe zugrunde, ein Leistungs-Halbleitermodul der genannten Art so weiterzubilden, daß mehrere Schaltungsvarianten lediglich durch Änderungen der Bondverbindungen im Gehäuse erhalten werden können.

Diese Aufgabe wird gelöst durch die Merkmale:
a) Für je zwei der nebeneinander liegenden Leistungs-Halbleiterschalter ist mindestens eine zusätzliche Leitbahn vorgesehen,
b) jede der zusätzlichen Leitbahnen ist wahlweise mit einer der Bondflächen und/oder mindestens einem der beiden nebeneinander liegenden Leistungs-Halbleiterschalter und/oder mit der zusätzlichen Leitbahn des benachbarten Leistungs-Halbleiterschalters über Bonddrähte verbindbar,
c) es sind mindestens sechs Laststromanschlüsse mit je einer Bondfläche vorgesehen,
d) die Leitbahnen von zwei nebeneinander liegenden Leistungs-Halbleiterschaltern sind direkt über Bonddrähte verbindbar.

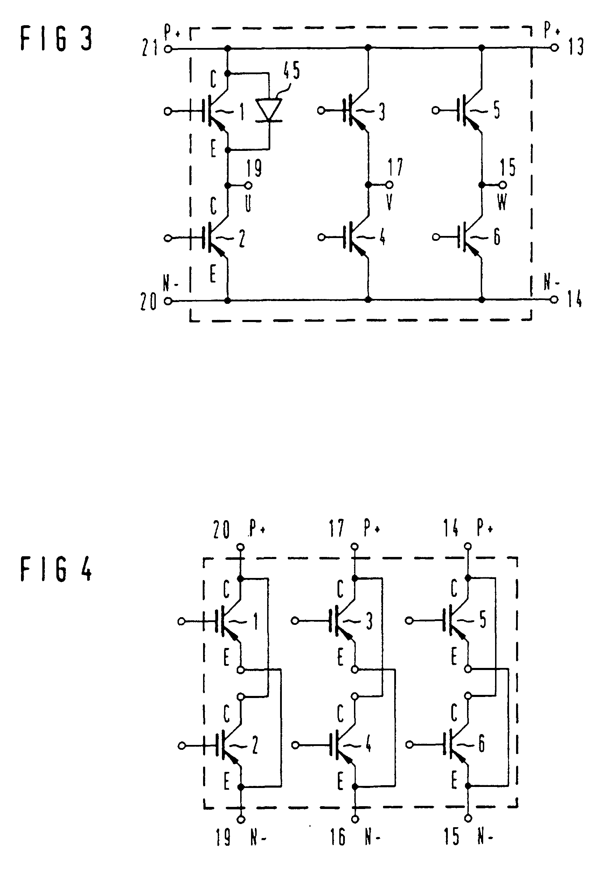

Weiterbildungen der Erfindung sind Gegenstand der Unteransprüche. Die Erfindung wird anhand zweier Ausführungsbeispiele in Verbindung mit den Figuren 1 bis 4 näher erläutert. Es zeigen:
- Figur 1: die Aufsicht auf ein Leistungs-Halbleitermodul, das als Dreiphasen-Stromrichterbrücke geschaltet ist,
- Figur 2: die Aufsicht auf ein Modul, das drei Einzelschalter enthält,
- Figur 3: die Schaltung des Moduls nach Figur 1 und
- Figur 4: die Schaltung des Moduls nach Figur 2.

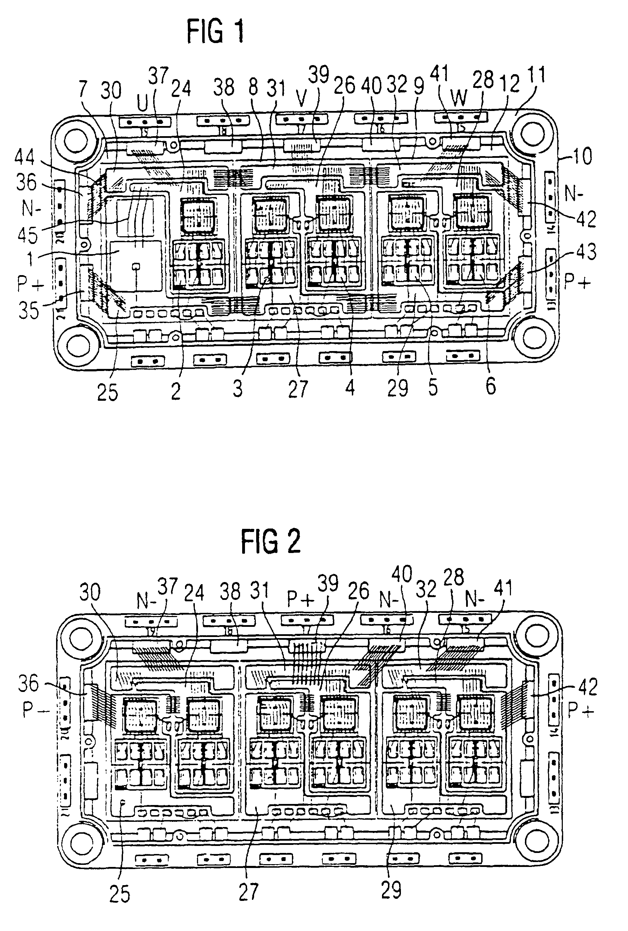

Das Leistungs-Halbleitermodul nach Figur 1 isc mit 10 bezeichnet. Es enthält einen metallenen Boden 12, mit dem ein Isolierstoffrahmen 11 befestigt ist. Der Isolierstoffrahmen bildet die Wände des Moduls und trägt sämtliche Lastanschlüsse 13 bis 21. Auf den Isolierstoffrahmen wird ein Deckel aufgesetzt (nicht dargestellt), Rahmen und Deckel bilden das Gehäuse.

Auf dem Boden 12 sind Substrate 7, 8, 9 befestigt. Diese bestehen z.B. aus Aluminiumoxid Al₂O₃ oder Aluminiumnitrid AlN. Ihre Unterseite ist mit einer Metallschicht versehen, über die die Substrate mit dem Boden 12 z.B. durch Löten verbunden sind. Die Oberseite der Substrate sind mit Leitbahnen 24, 25; 26, 27; 28, 29 versehen. Diese Leitbahnen tragen Leistungs-Halbleiterschalter 1, 2; 3, 4; 5, 6. Die Halbleiterschalter können z.B. IGBT (Isolated Gate Bipolar Transistor) sein, denen jeweils eine Freilaufdiode antiparallel geschaltet sein kann. Beim Leistungs-Halbleiterschalter 1 ist diese Diode mit 45 bezeichnet, bei den anderen Schaltern wurde die Bezeichnung der Diode der besseren Übersichtlichkeit halber weggelassen. Die Halbleiterschalter können auch MOSFET sein oder aus mehreren einander parallelgeschalteten Halbleiterbauelementen bestehen.

Jeweils zwei der nebeneinander liegenden Halbleiterschalter ist eine zusätzliche Leitbahn 30, 31, 32 zugeordnet. Die zusätzlichen Leitbahnen liegen vorzugsweise zwischen den Leitbahnen der Halbleiterschalter und mindestens einem Lastanschluß. Hat das Leistungs-Halbleitermodul Quaderform, so sind die meisten der Lastanschlüsse an der Längsseite des Gehäuses angeordnet. In diesem Fall sind dies die Lastanschlüsse 15, 16, 17, 18 und 19. Davon sind die Laststromanschlüsse 19, 17 und 15 der Wechselstromausgang mit den drei Phasen U, V und W. Die Anschlüsse 20, 14 an den Schmalseiten des Gehäuses sind die negative Gleichspannungsanschlüsse und die Anschlüsse 21, 13 die positiven. Es kann aber auch ausreichend sein, die Gleichspannung jeweils nur an die Laststromanschlüsse 13, 14 oder an 20, 21 anzulegen.

Die innere Verschaltung des Moduls erfolgt ausschließlich über Bondverbindungen. Dazu tragen die Laststromanschlüsse 21 bis 13 am unteren Ende Bondflächen 35, 36, 37, 38, 39, 40, 41, 42 und 43. Diese Bondflächen ragen in das Gehäuseinnere hinein. Die Oberseiten der Lastanschlüsse sind vorzugsweise als Stifte ausgebildet, über die das Modul mit einer Schaltungsplatine durch Schwallöten verbunden werden kann.

Im einzelnen verläuft der Laststrom des als Dreiphasen-Stromrichterbrücke geschalteten Moduls wie folgt: Anschluß 19 - Bondfläche 37 - Leitbahn 24 - Kollektor IGBT 2 - Emitter IGBT 2 - Leitbahn 30 - Bondfläche 36 - Anschluß 20. Außerdem fließt Strom vom Anschluß 13/21 - Leitbahn 25 - Kollektor IGBT 1 - Emitter IGBT 1 - Leitbahn 24 - Bondfläche 37 zum Lastanschluß 19.

Vom Lastanschluß 17 fließt Strom über die Bondfläche 39 - Leitbahn 26 - Kollektor IGBT 4 - Emitter IGBT 4 - Leitbahn 31 - Leitbahnen 30/32 zu den Lastanschlüssen 20/14. Außerdem fließt Strom vom Anschluß 13/21 über die Leitbahn 27 - Kollektor IGBT 3 - Emitter IGBT 3 - Leiterbahn 26 - Leitbahnen 25/29 zum Lastanschluß 17.

Vom Lastanschluß 15 fließt Strom über seine Bondfläche 41 - Leitbahn 28 - Kollektor IGBT 6 - Emitter IGBT 6 - Leitbahn 32 - Bondfläche 42 zum Lastanschluß 14 und über die Leitbahnen 31, 30 zum Lastanschluß 14/20. Außerdem fließt Strom vom Lastanschluß 13/21 über die Leitbahnen 25,27, 29 - Kollektor IGBT 5 - Emitter IGBT 5 - Leitbahn 28 - Bondfläche 41 zum Lastanschluß 15.

In der Figur 1 sind wegen der besseren Übersichtlichkeit die elektrischen Verbindungen innerhalb des Moduls jeweils durch drei Bonddrähte dargestellt. Bei hohen Strömen werden selbstverständlich mehr, z.B. 10 bis 15 parallele Bonddrähte verwendet. Hat ein solcher Bonddraht einen Durchmesser von z.B. 400 µm, so läßt sich damit eine Dreiphasen-Stromrichterbrücke mit z.B. 3 x 120 A Laststrom herstellen. Die antiparallelen Dioden bilden Bondstützpunkte für die Emitterseiten der IGBT.

Das Leistungs-Halbleitermodul nach Figur 2 hat bis auf die inneren, durch Bonddrähte geschalteten elektrischen Verbindungen den gleichen Aufbau wie das Leistungs-Halbleitermodul nach Figur 1. Auf die Bezeichnung der Halbleiterschalter bzw. IGBT wurde hier der besseren Übersichtlichkeit halber verzichtet. Die Laststromanschlüsse und die Leitbahnen sowie die Bondflächen tragen die gleiche Bezeichnung wie in Figur 1.

Das Leistungs-Halbleitermodul nach Figur 2 verkörpert drei Einzelschalter, bei denen jeweils die Halbleiterschalter 1 und 2, 3 und 4, 5 und 6 durch Bondverbindungen zwischen den Leitbahnen 24 und 25, 26 und 27, 28 und 29 sowie durch Bondverbindungen zwischen zwei benachbarten IGBT 1, 2; 3, 4; 5, 6 und der jeweils zugeordneten zusätzlichen Leitbahn 30, 31, 32 einander parallel geschaltet sind. Für den aus den IGBT 1 und 2 sowie den antiparallel geschalteten Dioden bestehenden ersten Einzelschalter ist der Lastanschluß 19 der negative Anschluß N- und der Lastanschluß 20 der positive Anschluß P+. Im einzelnen geht die elektrische Verbindung vom Lastanschluß 19 zum Lastanschluß 20 über die Bondfläche 37 - Leitbahn 30 - Emitter IGBT 1/IGBT 2 - Leitbahnen 24/25 - Bondfläche 36 - Lastanschluß 20. Für den zweiten Halbleiterschalter, der aus den IGBT 3 und 4 besteht, ist der Lastanschluß 17 der positive Anschluß P+ und der Anschluß 16 der negative Anschluß N-. Die Lastanschlüsse 17 und 16 sind verbunden über Bondfläche 39 - Leitbahnen 26/27 - Kollektor IGBT 3/IGBT 4 - Emitter IGBT 3/IGBT 4 - Leiterbahn 31 - Bondfläche 40 - Lastanschluß 16.

Für den aus den IGBT 5 und 6 bestehenden dritten Einzelschalter ist der Lastanschluß 15 der negative Gleichspannungsanschluß N- und der Lastanschluß 14 der positive Gleichspannungsanschluß P+. Beide sind elektrisch verbunden über die Bondfläche 41 - Leitbahn 32 - Emitter IGBT 5/IGBT 6 - Kollektor IGBT 5/IGBT 6 - Leitbahn 28/Leitbahn 29 - Bondfläche 42 - Lastanschluß 14.

Die auf der anderen Längsseite der Module liegenden Anschlüsse sind Steueranschlüsse, die über entsprechende Bondflächen mit den Gatekontakten und gegebenenfalls mit Hilfsemitterkontakten der IGBT verbunden sind. Der besseren Übersichtlichkeit halber wurden diese für die Erfindung nicht wesentlichen Komponenten nicht bezeichnet.

Wesentlich für die Erfindung ist, daß mindestens sechs Lastanschlüsse vorgesehen sind. Die Bondflächen dieser Lastanschlüsse müssen wahlweise mit einem der zusätzlichen Leitbahnen oder einem der mit einem IGBT versehenen Leitbahnen verbindbar sein. Dazu müssen die zusätzlichen Leitbahnen den Bondflächen direkt oder seitlich versetzt gegenüberliegen. An den Längsseiten des Gehäuses liegen die zusätzlichen Leitbahnen vorzugsweise zwischen den Bondflächen und den anderen Leitbahnen.

Zur Verbindung der einander benachbarten Leitbahnen 24, 27; 26, 29 (Figur 1) und 24, 25; 26, 27; 28, 29 (Figur 2) durch Bonddrähte weisen diese durch die Halbleiterschalter nicht belegte Flächen auf.

Einen Brückenzweig für dreifachen Laststrom erhält man dadurch, daß beim Modul nach Figur 1 die Anschlüsse 15, 17, 19 miteinander verbunden werden.

## Patentansprüche

1. Leistungs-Halbleitermodul mit einem Gehäuse und einem metallenen Boden, auf dem elektrisch isolierende und thermisch leitende, Leiterbahnen tragende Substrate angeordnet sind, mit sechs nebeneinander liegenden steuerbaren Leistungs-Halbleiterschaltern, die jeweils auf jeweils einer der Leiterbahnen elektrisch leitend befestigt sind, mit Laststromanschlüssen, die mit der Gehäusewand verbunden sind und die an der Unterseite im Inneren des Gehäuses Bondflächen haben, die über Bonddrähte elektrisch mit den steuerbaren Leistungs-Halbleiterschaltern verbunden sind,
**gekennzeichnet durch** die Merkmale:
a) für je zwei der nebeneinander liegenden Leistungs-Halbleiterschalter (1, 2; 3, 4; 5, 6) ist mindestens eine zusätzliche Leiterbahn (30, 31, 32) vorgesehen,
b) jede der zusätzlichen Leiterbahnen ist wahlweise mit einer der Bondflächen (35 bis 43) und/oder mindestens einem der beiden nebeneinander liegenden Leistungs-Halbleiterschalter und/oder mit der zusätzlichen Leiterbahn der benachbarten zwei Leistungs-Halbleiterschalter über Bonddrähte verbindbar,
c) es sind mindestens sechs Laststromanschlüsse mit sechs Bondflächen vorgesehen,
d) die Leiterbahnen von zwei nebeneinander liegenden Leistungs-Halbleiterschalterhsind direkt über Bonddrähte verbindbar.

2. Leistungs-Halbleitermodul nach Anspruch 1,
**dadurch gekennzeichnet, daß** das Gehäuse quaderförmig ausgebildet ist, daß mindestens einige der Laststromanschlüsse (15 bis 19) an einer der Längsseiten des Gehäuses angeordnet sind und daß die zusätzlichen Leiterbahnen zwischen den Leistungs-Halbleiterschaltern und der Längswand liegen.

3. Leistungs-Halbleitermodul nach Anspruch 1,
**dadurch gekennzeichnet, daß** jeweils zwei der nebeneinander liegenden Leistungs-Halbleiterschalter auf einem gemeinsamen Substrat (7, 8, 9) angeordnet sind.

4. Leistungs-Halbleitermodul nach Anspruch 3,
**dadurch gekennzeichnet, daß** die Substrate (7, 8, 9) und die Leiterbahnen (25, 27, 29) des ersten, dritten und fünften Halbleiterschalters einerseits und die (24, 26, 28) des zweiten, vierten und sechsten Halbleiterschalters andererseits einander gleich sind.

5. Leistungs-Halbleitermodul nach einem der Ansprüche 1 bis 4,
**dadurch gekennzeichnet, daß** die Leistungs-Halbleiterschalter IGBT sind.

6. Leistungs-Halbleitermodul nach Anspruch 5,
**dadurch gekennzeichnet, daß** jedem der IGBT eine Diode (45) antiparallel geschaltet ist.

7. Leistungs-Halbleitermodul nach Anspruch 1,
**dadurch gekennzeichnet, daß** jeder Leistungs-Halbleiterschalter aus mehreren parallel geschalteten Halbleiterbauelementen besteht.

## Claims

1. Power semiconductor module having a housing and a metallic base, on which electrically insulating and thermally conductive substrates which carry conductor tracks are arranged, having six controllable power semiconductor switches which are situated next to one another and are each electrically conductively fastened to a respective one of the conductor tracks, having load current connections which are connected to the housing wall and have bonding areas on the underside in the interior of the housing, said bonding areas being electrically connected to the controllable power semiconductor switches via bonding wires,
**characterized by** the following features:
a) at least one additional conductor track (30, 31, 32) is provided for every two of the power semiconductor switches (1, 2; 3, 4; 5, 6) situated next to one another,
b) each of the additional conductor tracks may be optionally connected, via bonding wires, to one of the bonding areas (35 to 43) and/or at least one of the two power semiconductor switches situated next to one another and/or to the additional conductor track of the adjacent two power semiconductor switches,
c) at least six load current connections having six bonding areas are provided,
d) the conductor tracks of two power semiconductor switches situated next to one another may be connected directly via bonding wires.

2. Power semiconductor module according to Claim 1,
**characterized in that** the housing is formed in parallelepipedal fashion, **in that** at least some of the load current connections (15 to 19) are arranged on one of the longitudinal sides of the housing and **in that** the additional conductor tracks are situated between the power semiconductor switches and the longitudinal wall.

3. Power semiconductor module according to Claim 1,
**characterized in that** two of the power semiconductor switches situated next to one another are respectively arranged on a common substrate (7, 8, 9).

4. Power semiconductor module according to Claim 3,
**characterized in that** the substrates (7, 8, 9) and the conductor tracks (25, 27, 29) of the first, third and fifth semiconductor switches, on the one hand, and those (24, 26, 28) of the second, fourth and sixth semiconductor switches, on the other hand, are identical to one another.

5. Power semiconductor module according to one of Claims 1 to 4,
**characterized in that** the power semiconductor switches are IGBTs.

6. Power semiconductor module according to Claim 5,
**characterized in that** a diode (45) is reverse-connected in parallel with each of the IGBTs.

7. Power semiconductor module according to Claim 1,
**characterized in that** each power semiconductor switch comprises a plurality of parallel-connected semiconductor components.

## Revendications

1. Module semi-conducteur de puissance comportant un boîtier et un fond métallique sur lequel sont disposés des substrats électriquement isolants et thermiquement conducteurs, portant des pistes conductrices, avec six interrupteurs de puissance commandables à semi-conducteurs, disposés les uns à côté des autres, fixés chacun de façon conductrice de l'électricité sur à chaque fois l'une des pistes conductrices, comportant des raccordements de courant de charge, reliés avec la paroi de boîtier et qui, sur le côté inférieur, à l'intérieur du boîtier, ont des surfaces de bonding reliées électriquement par des fils de bonding aux interrupteurs de puissance commandables à semi-conducteurs,
**caractérisé en ce que**
a) à chaque fois, pour deux interrupteurs de puissance à semi-conducteurs figurant l'un à côté de l'autre (1, 2 ; 3, 4 ; 5, 6), au moins une piste conductrice supplémentaire (30, 31, 32) est prévue,
b) chacune des pistes conductrices supplémentaires peut être au choix reliée par des fils de bonding à l'une des surfaces de bonding (35 à 43) et/ou au moins à l'un des deux interrupteurs de puissance à semi-conducteurs figurant l'un à côté de l'autre et/ou à la piste conductrice supplémentaire des deux interrupteurs de puissance à semi-conducteurs avoisinants,
c) au moins six raccordements de courant de charge avec six surfaces de bonding sont prévus,
d) les pistes conductrices de deux interrupteurs de puissance à semi-conducteurs figurant l'un à côté de l'autre peuvent être reliées directement par des fils de bonding.

2. Module semi-conducteur de puissance selon la revendication 1,
**caractérisé en ce que**
le boîtier est en forme de parallélépipède, et au moins certains des raccordements de courant de charge (15 à 19) sont disposés sur l'un des côtés longitudinaux du boîtier et les pistes conductrices supplémentaires figurent entre les interrupteurs de puissance à semi-conducteurs et la paroi longitudinale.

3. Module semi-conducteur de puissance selon la revendication 1,
**caractérisé en ce qu'**
à chaque fois deux des interrupteurs de puissance à semi-conducteurs figurant l'un à côté de l'autre sont disposés sur un substrat commun (7, 8,9).

4. Module semi-conducteur de puissance selon la revendication 3,
**caractérisé en ce que**
les substrats (7, 8, 9) et les pistes conductrices (25, 27, 29) du premier, du troisième et du cinquième interrupteur à semi-conducteurs d'une part, et ceux (24, 26, 28) du deuxième, du quatrième et du sixième interrupteur à semi-conducteurs, d'autre part, sont similaires les uns par rapport aux autres.

5. Module semi-conducteur de puissance selon l'une quelconque des revendications 1 à 4,
**caractérisé en ce que**
les interrupteurs de puissance à semi-conducteurs sont des IGBT.

6. Module semi-conducteur de puissance selon la revendication 5,
**caractérisé en ce qu'**
une diode (45) est raccordée de façon antiparallèle à chacun des IGBT.

7. Module semi-conducteur de puissance selon la revendication 1,
**caractérisé en ce que**
chaque interrupteur de puissance à semi-conducteurs se compose de plusieurs composants à semi-conducteurs raccordés en parallèle.
